# EUROPÄISCHE PATENTSCHRIFT

(11) **EP 3 104 117 B1**
(45) Veröffentlichungstag und Bekanntmachung des Hinweises auf die Patenterteilung: **06.11.2019**
(21) Anmeldenummer: 16173747.3
(22) Anmeldetag: 09.06.2016
(51) Int. Cl.: G01B 11/06, G01B 11/24, G01N 21/00, G01N 21/956, G06T 7/00, H04N 5/225, H04N 5/33, H04N 5/369

(54) **VERFAHREN ZUR FEHLERANALYSE VON DRAHTVERBINDUNGEN**
METHOD OF ANALYZING FAULTS IN WIRE CONNECTIONS
PROCEDE D'ANALYSE D'ERREURS DE LIAISONS FILAIRES

(30) Priorität: 12.06.2015 DE 102015109431
(43) Veröffentlichungstag der Anmeldung: 14.12.2016
(73) Patentinhaber: WiTrins s.r.o., 25064 Hovorcovice (CZ)
(72) Erfinder: Wieser, Roman Franz, 25064 Hovorcovice (CZ)
(74) Vertreter: advotec.

(56) Entgegenhaltungen:
- DE-A1- 10 100 892
- DE-A1- 10 208 978
- DE-A1-102005 031 490
- DE-A1-102012 104 745

## Beschreibung

Die Erfindung betrifft ein Verfahren zur Fehleranalyse einer Drahtverbindung zwischen einem Substrat und einem Halbleiterbauelement eines Produkts mit den Merkmalen des Oberbegriffs des Anspruch 1.

Bei dem vorbezeichneten Inspektionssystem bzw. Verfahren zur Fehleranalyse einer Drahtverbindung werden durch sogenanntes Drahtbonden hergestellte Drahtverbindungen bzw. Bonds auf mögliche Fehler hin analysiert. Das Halbleiterbauelement kann ein integrierter Schaltkreis, wie ein Chip, oder auch ein diskretes Halbleiterbauelement, wie ein Transistor oder eine Leichtdiode, sein, wobei das Halbleiterbauelement über einen Draht bzw. Bonddraht mit Anschlussflächen eines Substrats verbunden wird. Das Verbinden der Anschlussfläche des Substrats mit einer Anschlussfläche des Halbleiterbauelements kann mit einem hinreichend aus dem Stand der Technik bekannten Verfahren, wie beispielsweise TC-, TS- oder US-Bonden erfolgen. Der verwendete Draht besteht dabei regelmäßig aus Gold, Aluminium, Silber oder Kupfer und kann einen Durchmesser von 10 bis 500 µm aufweisen. Sogenannte Dünndrähte weisen einen Durchmesser von 10 bis 20 µm auf und erlauben enge Strukturen der Anschlussflächen und damit besonders hohe Packungsdichten. Bei einer Herstellung derartiger Drahtverbindungen durch Drahtbonden können jedoch auch Fehler auftreten, wie beispielsweise sich berührende benachbarte Drähte oder ein nicht mit einer Anschlussfläche kontaktiertes Drahtende. Die entsprechenden Produkte bzw. Drahtverbindungen werden daher optisch auf Fehler hin analysiert.

Aus dem Stand der Technik sind Verfahren bekannt, bei denen mittels einer Videokamera Bilder von Drahtverbindungen zwischen einem Substrat und einem Halbleiterbauelement aufgenommen und verarbeitet werden. Das zu analysierende Produkt wird dabei beleuchtet und die mit der Videokamera erfassten Bildinformationen werden zur Erkennung der jeweiligen Drahtverbindungen verarbeitet und auf Fehler hin analysiert. Beispielsweise ist es bekannt, Drahtverbindungen mit einer Matrixkamera einzeln anzufahren, was bei einer Vielzahl von Drahtverbindungen bzw. Halbleiterbauelementen auf einem Substrat relativ zeitaufwendig und damit kostenintensiv ist. Weiter ist es bekannt mittels einer Zeilenkamera das Substrat mit dem Halbleiterbauelement und den jeweiligen Drahtverbindungen vollständig in einem Durchlauf zu scannen. Eine Beleuchtung eines Erfassungsbereichs der Zeilenkamera auf dem Produkt erfolgt dabei mit schräg einfallendem Licht aus zwei Richtungen jeweils parallel zur Längserstreckung der Zeilenkamera. So sollen Abschattungen durch die Drähte der Drahtverbindungen oder Halbleiterbauelemente, wie sie bei einer alleinigen Verwendung eines Auflichts auftreten, verhindert werden. Beispielsweise ist alleine Auflicht bei übereinanderliegenden Drahtverbindungen aufgrund von Abschattungen nicht geeignet.

Um ein besonders zuverlässiges Messergebnis zu erhalten, ist es jedoch selbst bei den bekannten Verfahren zur Fehleranalyse erforderlich mehrere Durchläufe bzw. Scans des Produkts am Inspektionssystem durchzuführen, eventuell auch zum Aufspüren unterschiedlicher Fehlerarten. Das Problem bei der Bildverarbeitung der erfassten Bildinformationen besteht insbesondere darin, die jeweiligen Drahtverbindungen zuverlässig zu erkennen und gegebenenfalls bei mehreren Durchläufen die Bildinformationen einander zuzuordnen. Dies ist aufgrund der dann erforderlichen Durchläufe des Produkts am Inspektionssystem und der erfassten Datenmengen vergleichsweise zeitaufwendig und damit mit hohen Kosten verbunden.

Aus der DE 101 00 892 A1 ist eine Vorrichtung bzw. ein Verfahren zur Inspektion von Drahtverbindungen auf einer Platine bekannt. Mittels einer Projektionsvorrichtung wird ein Lichtspalt schräg auf die Platine projiziert und von einer orthogonal oberhalb der Platine angeordneten Zeilenkamera aufgenommen. Weiter kann eine zweite Projektionsvorrichtung zur Erzeugung einer diffusen Beleuchtung vorgesehen sein. Dabei ist beabsichtigt, zunächst eine Aufnahme mit Auflicht, und mit einem weiteren Scan, eine Aufnahme mit schräg von vorne einfallendem Licht anzufertigen, wobei diese Aufnahmen im Rahmen einer Auswertung überlagert werden können.

Die DE 10 2012 104 745 A1 offenbart ein Inspektionssystem zur Inspektion von Oberflächen, insbesondere von Schweiß- oder Lötnähten. Das Inspektionssystem umfasst eine Kamera und eine Beleuchtungseinrichtung, mit der ein Lichtspalt orthogonal zu einer Oberfläche auf diese projizierbar ist. Die Kamera ist in einem Abstand, parallel zu der Beleuchtungseinrichtung angeordnet, sodass ein Reflektionsbild des Lichtspalts auf der Oberfläche erfasst werden kann. Dadurch dass die Kamera parallel zur Beleuchtungseinrichtung angeordnet ist, wird es möglich mittels Triangulation eine Höhe der betreffenden Oberfläche zu bestimmen und eventuelle Aufwölbungen oder Einbuchtungen zu detektieren. Eine weitere Beleuchtungseinrichtung des Inspektionssystems ist aus einer Anzahl von Leuchtdioden gebildet, die ebenfalls oberhalb der Oberfläche angeordnet sind. Durch diese Leuchtdioden soll die Oberfläche diffus beleuchtet werden, wobei dann eine zweidimensionale Aufnahme der Oberfläche ebenfalls mittels der Kamera erfolgt. Prinzipiell wird hier eine Flächenkamera verwendet, jedoch ist vorgesehen, nur einzelne Zeilen der Flächenkamera, nämlich die mit den größten Helligkeitswerten auszuwerten.

Der vorliegenden Erfindung liegt daher die Aufgabe zugrunde, ein Verfahren zur Fehleranalyse von Drahtverbindungen vorzuschlagen, welches eine verlässliche und schnelle Fehleranalyse ermöglicht.

Diese Aufgabe wird durch ein Verfahren mit den Merkmalen des Anspruchs 1 gelöst.

Bei dem erfindungsgemäßen Verfahren zur Fehleranalyse einer Drahtverbindung zwischen einem Substrat und einem Halbleiterbauelement eines Produkts, mit einem Inspektionssystem, umfasst das Inspektionssystem eine erste Projektionsvorrichtung, eine Zeilenkamera und eine Verarbeitungsvorrichtung, wobei die erste Projektionsvorrichtung zumindest eine Spaltprojektionseinrichtung aufweist, wobei mittels der Spaltprojektionseinrichtung ein Lichtspalt auf einen Draht der Drahtverbindung projiziert wird, wobei in einer quer, vorzugsweise orthogonal, zu einer Substratoberfläche verlaufenden Erfassungsebene der Zeilenkamera am Draht reflektiertes Licht des Lichtspalts mittels der Zeilenkamera erfasst wird, wobei mittels der Verarbeitungsvorrichtung aus einer Mehrzahl von Zeilenbildinformationen der Zeilenkamera eine Analysebildinformation des Produkts abgeleitet wird, wobei der Lichtspalt innerhalb der Erfassungsebene verlaufend auf das Produkt projiziert wird, wobei die Spaltprojektionseinrichtung seitlich quer relativ zu der Zeilenkamera so angeordnet ist, dass der Lichtspalt auf den Draht projiziert wird, wobei das Inspektionssystem eine zweite Projektionsvorrichtung umfasst, wobei die zweite Projektionsvorrichtung zumindest eine Beleuchtungseinrichtung aufweist, wobei mittels der Beleuchtungseinrichtung diffuses Licht auf das Produkt projiziert wird, wobei am Produkt in der Erfassungsebene reflektiertes Licht des diffusen Lichts mittels der Zeilenkamera erfasst wird, wobei das Halbleiterbauelement von dem Lichtspalt unbeleuchtet ist..

Insbesondere dadurch, dass der Lichtspalt innerhalb der Erfassungsebene verlaufend auf den Draht projiziert wird, kann der in der Erfassungsebene liegende Draht im Wesentlichen alleine in der Erfassungsebene von schräg oben, d.h. mit dem Lichtspalt als Auflicht beleuchtet werden. Auch die Zeilenkamera ist dann auf den Draht fokussiert, so dass dieser sehr gut erfassbar ist. Dadurch wird es möglich, eine Erkennung eines Drahts bei einer nachfolgenden Bildverarbeitung der Analysebildinformation wesentlich zu verbessern und Fehler zu vermeiden. Die Mehrzahl von eindimensionalen Zeilenbildinformationen der Zeilenkamera wird in der Verarbeitungsvorrichtung zu der zweidimensionalen Analysebildinformation kombiniert bzw. zusammengesetzt. Demnach wird mit dem Inspektionssystem das Produkt über die Zeilenkamera gescannt, indem das Produkt relativ zum Inspektionssystem bewegt wird. Der Lichtspalt verläuft relativ zum Substrat bzw. Halbleiterbauelement vorzugsweise vertikal und ist gerichtet bzw. zumindest in Längsrichtung eines Querschnitts des Lichtspalts kollimiert. Durch die so verbesserte Erkennung einer Drahtverbindung wird es möglich, ein Produkt bereits in einem Durchlauf bzw. Scan einer verlässlichen Fehleranalyse zu unterziehen. Weiter kann mit der Beleuchtungseinrichtung diffuses bzw. homogenes Licht auf das Produkt projiziert werden, wobei das reflektierte Licht des diffusen Lichts in der Erfassungsebene dann von der Zeilenkamera aufgenommen werden kann. So wird es dann möglich, eine Lage des Halbleiterbauelements auf dem Substrat und eine Relativposition der Drahtverbindungen bzw. Drähte mittels Bildverarbeitung durch die Verarbeitungsvorrichtung zu bestimmen. Weiter können auch eventuelle Abschattungen durch das gerichtete Licht des Lichtspalts mit dem diffusen Licht beleuchtet und so aufgenommen bzw. erkannt werden. Eine Beleuchtung des Produkts mit dem diffusen Licht durch die Beleuchtungseinrichtung bzw. zweite Projektionsvorrichtung kann in einem separaten Durchlauf des Produkts mit dem Inspektionssystem oder auch zusammen mit der Projektion des Lichtspalts alleine in einem Durchlauf erfolgen.

Optional kann auch anstelle einer originären Zeilenkamera ein Contact Imaging Sensor (CIS) oder eine Flächenkamera, bei der wie bei einer Zeilenkamera nur eine oder wenige Zeilen genutzt werden, verwendet werden.

Erfindungsgemäß wird die Spaltprojektionseinrichtung seitlich quer relativ zu der Zeilenkamera so angeordnet, dass der Lichtspalt auf den Draht projiziert wird, derart, dass das Halbleiterbauelement von dem Lichtspalt unbeleuchtet ist. Die Spaltprojektionseinrichtung kann dann an einem Längsende der Zeilenkamera angeordnet sein. So ist auch sichergestellt, dass dann der Lichtspalt innerhalb der Erfassungsebene verläuft. Der Lichtspalt kann dann auch seitlich von oben auf den Draht projiziert werden. Folglich verläuft der Lichtspalt dann relativ zur Zeilenkamera mit dieser fluchtend und quer bzw. orthogonal zu der Bewegungsrichtung. So wird dadurch, dass der Lichtspalt ausschließlich innerhalb der Erfassungsebene verläuft und folglich von seitlich neben der Zeilenkamera auf das Produkt projizierbar ist, die Möglichkeit eröffnet, das Halbleiterbauelement und ggf. auch das Substrat nicht mit dem Lichtspalt zu beleuchten bzw. unbeleuchtet zu belassen. Da dann zumindest das Halbleiterbauelement nicht von dem Lichtspalt beleuchtet wird, erscheint das Halbleiterbauelement in der Analysebildinformation bzw. dem erfassten Bild des Produkts im Wesentlichen überhaupt nicht oder erkennbar dunkel mit einem hohen Kontrast relativ zu dem mit dem Lichtspalt direkt beleuchteten Draht.

Mittels der Verarbeitungsvorrichtung kann die Mehrzahl von Zeilenbildinformationen der Zeilenkamera in einer Bewegungsrichtung des Produkts mit einem Versatz überlagert werden, wobei der Versatz kleiner sein kann als eine physikalische Bildauflösung der Zeilenkamera. Bei dem Scannen des Produkts mittels des Inspektionssystems kann das Produkt in einer ersten Position mit der Spaltprojektionseinrichtung und/oder der Beleuchtungseinrichtung beleuchtet werden und dann in eine zweite und weitere Positionen relativ zur Zeilenkamera bewegt werden, wobei dann eine Erfassung von Zeilenbildinformationen analog zur ersten Position erfolgt. So kann ein Scan einer gesamten Oberfläche des Produkts oder auch nur der Drahtverbindungen des Produkts durchgeführt werden, wobei das Produkt bzw. die Drahtverbindungen dann von den Projektionsvorrichtungen vollständig beleuchtet wurden. Dabei kann vorgesehen sein, dass ein Versatz von der ersten Position zu der zweiten und weiteren Position mit einer Überlappung von zumindest ⅓ Pixel folgt. Wenn beispielsweise ein Draht einen Durchmesser von 18 µm aufweist, kann das Produkt von der ersten Position in die jeweils weitere Position in Schritten von 2 µm bewegt werden, wobei dann eine Auflösung des entsprechenden Bild bzw. der Analysebildinformation von 3 bis 8 µm erzielt werden kann. So kann ein voll auflösendes Bild bzw. eine Analysebildinformation erhalten werden, wobei eventuell nicht erfasste Bildbereiche unterhalb einer möglichen Auflösung der Zeilenkamera liegen. Weiter ist es auch möglich, eine beliebige Anzahl von n-Farbbildern in einem Scan zu erfassen, wobei die n-Farbbilder n-Informationsmöglichkeiten repräsentieren. Hier kann in Abhängigkeit der zur inspizierenden Merkmale des Produkts hinsichtlich Beleuchtungsstärke, Lichtfarbe, Beleuchtungswinkel und Beleuchtungstechnologie entsprechend variiert werden.

Das Produkt kann einmalig in Richtung einer X-Achse und/oder einer Y-Achse des Produkts relativ zur Zeilenkamera bewegt und optisch abgetastet werden, wobei den Projektionsvorrichtungen zugeordnete Analysebildinformationen gewonnen werden können. Je nach Anordnung der Drahtverbindungen kann das Produkt in Richtung der X-Achse, und wenn erforderlich nachfolgend in Richtung der Y-Achse einmalig relativ zur Zeilenkamera bewegt werden. Dies kann insbesondere auch dadurch ermöglicht werden, dass die Projektionsvorrichtungen und die Zeilenkamera synchronisiert sein können, wobei die Synchronisation dann die Zuordnung der Analysebildinformationen ermöglicht. Eine Fehleranalyse eines Produkts kann so auf einen einmaligen Scan der Oberfläche des Produkts bzw. der Drahtverbindungen beschränkt und damit wesentlich verkürzt und vereinfacht werden.

Weiter kann das Produkt in zumindest zwei Ebenen einer Z-Achse des Produkts optisch abgetastet werden. Da die Drahtverbindungen bzw. Drähte regelmäßig bogenförmig aufrecht auf der Oberfläche des Produkts stehend angeordnet sind, ist es gegebenenfalls erforderlich zur vollständigen Erfassung eines Drahts einen Fokus der Zeilenkamera zu variieren, oder einen Abstand der Zeilenkamera zum Produkt zu verändern, um eine vollständig scharfe Abbildung des Drahts zu erhalten. Je nach Höhe des Drahts relativ zur Oberfläche bzw. Erstreckung in der Z-Achse kann das Produkt bzw. der betreffende Bereich der Drahtverbindungen in zumindest zwei Ebenen der Z-Achse gescannt werden.

Um eine Fehleranalyse des Produkts bzw. der Drahtverbindungen möglichst schnell durchführen zu können, können die Lichtstrahlen bzw. das Licht der Projektionsvorrichtungen in einer zeitlichen Abfolge auf das Produkt projiziert werden, wobei die Zeilenkamera mit den Projektionsvorrichtungen synchronisiert sein kann. Beispielsweise kann ein Produkt unterhalb der Zeilenkamera in Richtung einer X-Achse bewegt werden, wobei zur Erfassung einer geometrischen Lage eines Drahts in einer ersten Position zunächst eine Beleuchtung eines Untersuchungsbereichs der Oberfläche des Produkts mittels der ersten Projektionsvorrichtung bzw. Spaltprojektionseinrichtung erfolgt, wobei die Zeilenkamera eine Bildinformation des Oberflächenbereichs erfasst. Die Bildinformation kann mittels eines Framegrabbers von der Verarbeitungsvorrichtung verarbeitet und abgespeichert werden. Danach kann von der zweiten Projektionsvorrichtung bzw. der Beleuchtungseinrichtung der Oberflächenbereich beleuchtet werden und eine entsprechende Bildinformation, beispielsweise eine Materialinformation, von der Zeilenkamera erfasst sowie von der Verarbeitungsvorrichtung verarbeitet werden. Auch kann bei der zweiten Projektionsvorrichtung vorgesehen sein, dass der Oberflächenbereich nacheinander mit Licht in den Grundfarben Rot, Grün und Blau beleuchtet wird, wobei die Zeilenkamera dann die Grundfarben getrennt voneinander erfassen kann. D.h. für den Oberflächenbereich der ersten Position können eine Reihe verschiedener Bildinformationen seriell erfasst werden. Dazu ist es dann erforderlich, dass die Zeilenkamera mit den Projektionsvorrichtungen synchronisiert ist. Wenn beispielsweise mittels der zweiten Projektionsvorrichtung rotes Licht auf das Produkt projiziert wird, kann vorgesehen sein, dass für den Zeitraum der Projektion von der Zeilenkamera rotes Licht erfasst wird. Alternativ ist es auch möglich, dass von der Zeilenkamera dann die Grundfarben getrennt voneinander oder zusammen erfasst werden, jedoch immer eine Zuordnung der Bildinformation zu der jeweiligen Beleuchtungssituation möglich ist. Insbesondere wenn die Erfassung der Grundfarben für eine Position nacheinander bzw. seriell erfolgt, kann ein voll auflösendes Bild bzw. eine Analysebildinformation des Produkts erhalten werden.

Aus einer Verteilung des auf einer Oberfläche des Drahts reflektierten Lichtstrahls können mittels der Verarbeitungsvorrichtung eine Höheninformation und/oder geometrische Informationen des Drahts ermittelt werden. Die Verarbeitungsvorrichtung kann so eingerichtet sein, dass aus einer Verteilung des auf der Oberfläche des Produkts bzw. des Drahts reflektierten Lichtspalts der Spaltprojektionseinrichtung mittels der Verarbeitungsvorrichtung eine Relativposition des Lichtspalts auf der Oberfläche des Produkts bzw. Drahts ermittelt werden kann. Aus einem Reflexionsbild des Produkts bzw. des Drahts kann mit der Verarbeitungsvorrichtung anhand einer Normalverteilung einer Leuchtdichte beispielsweise eine geometrische Information des Drahts gewonnen werden. So kann auch ein Maximalwert bzw. Maximum der Dichtefunktion der Normalverteilung der Leuchtdichte auf der Oberfläche des Drahts bestimmt werden, woraus dann auch eine Höheninformation abgeleitet werden kann. Alternativ ist es auch möglich, mit einer zweiten Zeilenkamera, die parallel zur Zeilenkamera bzw. ersten Zeilenkamera angeordnet ist, eine Höheninformation des Drahts durch Triangulation zu ermitteln.

Insbesondere kann vorgesehen sein, dass mittels der Verarbeitungsvorrichtung das vom Produkt reflektierte Licht des homogenen bzw. diffusen Lichts hinsichtlich Farbton, Helligkeit und/oder Sättigung analysiert wird. So kann mittels der Verarbeitungsvorrichtung eine Analyse der Analysebildinformationen bzw. RGB-Farbbildinformationen getrennt nach dem Farbwert (hue), der Farbsättigung (saturation) und Hellwert (value) in einem Farbraum (HSV, HSL, HSB) durchgeführt werden. Die Bildinformationen können insbesondere zur Analyse der Materialart und Verteilung verwendet werden, da verschiedene Materialien verschiedene H-, S- und V-Werte aufweisen. Eine Auswahl eines Farbraums kann in Abhängigkeit von den zu analysierenden Materialien erfolgen, wobei als Basis ein RGB-Farbraum dienen kann.

Mittels der Verarbeitungsvorrichtung können so aus mit der zweiten Projektionsvorrichtung gewonnenen Analysebildinformationen ein Material und/oder eine Materialeigenschaft eines Produkts bestimmt werden.

Weitere Material- und Strukturinformationen eines Produkts können gewonnen werden, wenn mittels der Verarbeitungsvorrichtung den Projektionsvorrichtungen zugeordnete Analysebildinformationen überlagert und ausgewertet werden. Mit einer Kombination von Analysebildinformationen, wie beispielsweise bei Hochkontrastbildern (HDRI), kann beispielsweise auch eine höhere Kontrastverbesserung erreicht werden und auch Materialmischungen auf einer Oberfläche des Produkts analysiert werden. Gerade besonders kontrastschwache Flächen können dann kombiniert inspiziert werden. Dabei werden dann zumindest zwei Analysebildaufnahmen eines Bereichs von beispielsweise Drahtverbindungen mit unterschiedlichen Helligkeiten bzw. bei unterschiedlichen Beleuchtungsstärken aufgenommen und mittels Bildverarbeitung der Verarbeitungsvorrichtung kombiniert. Optional kann eine Beleuchtung mit der Spaltprojektionseinrichtung und der Beleuchtungseinrichtung in einer Abfolge erfolgen. Dabei wird dann zunächst eine erste Zeilenbildinformation bzw. Analysebildinformation bei alleine einer Beleuchtung mit der Spaltprojektionseinrichtung und nachfolgend eine zweite Zeilenbildinformation bzw. Analysebildinformation bei alleine einer Beleuchtung mit der Beleuchtungseinrichtung aufgenommen. Die jeweiligen Analysebildinformationen werden dann mittels Bildverarbeitung kombiniert. Dabei kann dann nicht nur eine Lage der Drahtverbindungen, sondern auch eine Position von Anschlussflächen erkannt werden.

Weiter kann im Rahmen einer Fehleranalyse mittels der Verarbeitungsvorrichtung ein Vergleich von Analysebildinformationen mit Referenzbildinformationen erfolgen. Die Referenzbildinformationen des Produkts bzw. der jeweiligen Drahtverbindungen können CAD-Daten und Materialverteilungsdaten des Produkts umfassen. Der Vergleich kann durch Bildverarbeitung erfolgen, wobei für unterschiedliche Strukturen des Produkts bzw. Anordnungen von Drähten jeweils getrennt voneinander Differenzbilder analysiert werden können. Weiter können diese Materialinformationen mit Höheninformationen kombiniert werden, um beispielsweise einen Draht eindeutig zu identifizieren. Die Referenzbildinformationen können demnach sämtliche geometrischen Daten des Produkts, Materialinformationen, Bauteilinformationen und auch Höheninformationen umfassen. Weichen die Analysebildinformationen von den Referenzbildinformationen ab, kann ein Fehler signalisiert werden. Dies ist jedoch nicht zwingend notwendig, wenn Toleranzbereiche definiert sind, die beispielsweise eine geometrische Abweichung einer Drahtverbindung von einer Referenzposition ermöglicht. So können benachbarte Drahtverbindungen innerhalb des Toleranzbereiches sich annähern oder voneinander entfernt sein, solange ein Kurzschluss vermieden wird. Diese Untersuchung eines Differenzbildes erfordert dann eine eindeutige Zuordnung von Analysebildinformationen zur Referenzbildinformation. Grundsätzlich ist jedoch ein Vergleich der Analysebildinformationen mit Referenzbildinformationen nicht zwingend erforderlich. So kann zur Fehleranalyse bereits ausreichend sein, alleine eine Lage der jeweiligen Drahtverbindungen zu detektieren und einen Fehler zu signalisieren, wenn sich die jeweiligen Drahtverbindungen innerhalb eines definierten Toleranzbereiches annähern.

Die Zeilenkamera kann quer zu einer Bewegungsrichtung eines Produkts angeordnet werden, wobei die Erfassungsebene dann parallel oder quer zu dem Draht verläuft. Dadurch wird es möglich, die Drähte im Wesentlichen vollständig oder zumindest teilweise mit einer einzelnen Aufnahme der Zeilenbildkamera bzw. einer Zeilenbildinformation der Zeilenkamera zu erfassen. Folglich sind dann die zu prüfenden Drähte bei einem Durchlauf des Produkts durch das Inspektionssystem quer zur Bewegungsrichtung des Produkts angeordnet. Beispielsweise kann dann vorgesehen sein, das Produkt jeweils nach der Lage der Drähte bzw. Drahtverbindungen relativ zur Zeilenkamera auszurichten. Verfügt das Produkt nicht alleine über parallel angeordnete Drahtverbindungen, sondern auch um beispielsweise 90 Grad versetzt angeordnete Drahtverbindungen, können auch zwei Durchläufe im Inspektionssystem mit entsprechend angepasster Ausrichtung des Produkts relativ zur Zeilenkamera vorgesehen sein.

Vorteilhaft kann die Spaltprojektionseinrichtung zumindest eine Abschirmblende zur Abgrenzung des Lichtspalts gegenüber dem Halbleiterbauelement und ggf. dem Substrat aufweisen, wobei der Lichtspalt unter einem spitzen Winkel α relativ zu einer Oberfläche des Produkts auf den Draht projiziert werden kann. Mit der Abschirmblende wird es dann möglich, den Lichtspalt einzugrenzen, so dass der Lichtspalt alleine auf den Draht oder gegebenenfalls das Substrat auftrifft. Dabei kann vorgesehen sein, dass eine Höhe der Spaltprojektionseinrichtung relativ zu der Oberfläche des Produkts sowie die Abschirmblende einstellbar ausgebildet sind. Weiter kann die Spaltprojektionseinrichtung eine weitere Abschirmblende zur Abgrenzung des Lichtspalts gegenüber der Zeilenkamera aufweisen, so dass sichergestellt ist, dass Licht des Lichtspalts nicht in die Zeilenkamera fällt. Wenn die Spaltprojektionseinrichtung bzw. Abschirmblende variabel einstellbar ausgebildet ist, kann das Inspektionssystem bzw. die Spaltprojektionseinrichtung auf unterschiedlichste Produkte eingestellt werden, so dass das Inspektionssystem flexibel für diese Produkte einsetzbar ist. Bei der Einstellung der Spaltprojektionseinrichtung kann beispielsweise die Abschirmblende oder die Spaltprojektionseinrichtung selbst so angeordnet sein, dass der Lichtspalt unter dem Winkel α auf den Draht und das Substrat fällt, ohne dass das Halbleiterbauelement erkennbar von dem Licht des Lichtspalts beleuchtet wird.

Die Spaltprojektionseinrichtung kann eine Anordnung von optischen Elementen, eine Aperturblende und/oder eine Lichtleiteranordnung aufweisen, wobei der Lichtspalt ein kollimierter Lichtspalt sein kann. Die optischen Elemente können beispielsweise eine oder mehrere Linsen bzw. Zylinderlinsen sein. Die Aperturblende kann entsprechend der Form des Lichtspalts spaltförmig ausgebildet sein, wobei auch weitere Aperturblenden und eine Kombination der Aperturblende mit optischen Elementen vorgesehen sein können. Darüber hinaus kann eine Lichtleiteranordnung vorgesehen sein, wobei die Lichtleiteranordnung aus einem einzelnen Lichtleiter in Form eines Spaltes oder aus einer Vielzahl von Lichtleiterfasern, die in Form eines Spaltes angeordnet sind, ausgebildet sein. Als eine Lichtquelle können beispielsweise Leuchtdioden dienen. So kann eine Leuchtdiode zur Einkopplung von Licht in die Lichtleiteranordnung oder eine Mehrzahl von Leuchtdioden in einer Reihenanordnung vorgesehen sein. Insbesondere ist die Verwendung einer Lichtleiteranordnung als besonders vorteilhaft, dadurch, dass dann die Lichtquelle weiter beabstandet angeordnet werden, und dann die Spaltprojektionseinrichtung in einem Bereich seitlich neben der Zeilenkamera und/oder parallel dazu vergleichsweise klein und damit auch gut einstellbar bzw. positionierbar ausgebildet werden kann.

Die Beleuchtungseinrichtung kann einen bogenförmigen Diffusor aufweisen, wobei der bogenförmige Diffusor seitlich parallel relativ zu der Zeilenkamera bzw. orthogonal zu einer Bewegungsrichtung eines Produkts angeordnet werden kann. Wenn der Diffusor bogenförmig ist, kann der Diffusor besonders gut an eine Form des Drahts angepasst sein, so dass eine verbesserte Beleuchtung des Drahts für eine Aufnahme mit der Zeilenkamera möglich ist. Weiter wird dann auch sichergestellt, dass eventuelle Abschattungen durch den Draht oder Bauteilkanten des Halbleiterbauelements vermieden werden, da der Draht bzw. das Halbleiterbauelement von mehreren Seiten durch den bogenförmigen Diffusor beleuchtet werden können. Dies ist insbesondere auch besonders vorteilhaft, wenn mehrere übereinander liegende Drahtverbindungen, beispielsweise an einem Chip mit in einer Höhe versetzten Anschlussflächen, existent sind. Durch die bogenförmige Ausbildung des Diffusors wird es weiter möglich, den Diffusor sehr dicht an den zu analysierenden Bereich des Produkts bzw. das Halbleiterbauelement heranzuführen. Wenn das Produkt bzw. das Halbleiterbauelement bereits in einem Gehäuse bzw. das Halbleiterbauelement in einem Chipgehäuse verbaut ist, kann das diffuse Licht unmittelbar in die Nähe der Drahtverbindungen gebracht werden, indem der bogenförmige Diffusor zumindest teilweise in das Gehäuse hinein bewegt bzw. dort angeordnet wird. So können dann auch eventuelle Abschattungen durch das Gehäuse vermieden werden. Der Diffusor kann auch mit einer Blende bzw. Apertur versehen sein, die so ausgebildet ist, dass das Substrat oder das Halbleiterbauelement im Wesentlichen unbeleuchtet ist. Darüber hinaus kann der bogenförmige Diffusor bzw. die Beleuchtungseinrichtung einstellbar ausgebildet sein, in der Art, dass der bogenförmige Diffusor am Inspektionssystem bewegt und an eine Geometrie des jeweils zu untersuchenden Produkts angepasst wird.

Ergänzend kann die Beleuchtungseinrichtung einen ebenen Diffusor aufweisen, wobei der ebene Diffusor parallel relativ zu dem Produkt angeordnet werden kann. So kann das Produkt bzw. Substrat noch mit einem diffusen Licht direkt von oben, also orthogonal relativ zum Produkt bzw. Substrat beleuchtet werden. Hierdurch können weitere unabhängige Informationen gewonnen werden.

Die Beleuchtungseinrichtung kann mit einer Lichtleiteranordnung oder Leuchtdioden in einer bogenförmigen und/oder ebenen Anordnung verwendet werden. Die Lichtleiteranordnung kann ein einzelner Lichtleiter oder ein Bündel von Lichtleiterfasern sein, in die jeweils Licht von beispielsweise Leuchtdioden eingekoppelt wird. Wesentlich ist, dass bei einer Verwendung von Lichtleitfasern die Lichtquelle auch weit von der eigentlichen Beleuchtungseinrichtung entfernt angeordnet werden kann, wodurch die Beleuchtungseinrichtung dann kompakt und einfach einstellbar ist. Je nach Ausführung der Lichtleiteranordnung oder Leuchtdioden können diese alleine eben und/oder bogenförmig oder zusammen mit einem ebenen bzw. bogenförmigen Diffusor, beispielsweise einer Diffusorscheibe oder Folie eingesetzt werden.

Die Beleuchtungseinrichtung und/oder die Spaltprojektionseinrichtung kann Licht der Wellenlängenbereiche Rot, Grün und Blau (RGB), Infrarot (IR) und/oder Ultraviolett (UV) emittieren. Insbesondere wird es dann möglich, polychromatisches Licht, sogenanntes Weißlicht im sichtbaren Bereich zur Beleuchtung zu verwenden. Auch kann vorgesehen, Farbanteile des Lichts beliebig auszuwählen, um bestimmte Wellenlängenbereiche zu mischen. Beispielsweise eignet sich blaues und gelbes Licht zur Beleuchtung des Materials Gold, wodurch dann aus Gold bestehende Drähte besonders gut mittels der Zeilenkamera erkennbar sind. Je nach verwendetem Material des Substrats, des Halbleiterbauelements und der jeweiligen Anschlussflächen kann dann ein hoher Farbkontrast erhalten werden. Auch können die Beleuchtungseinrichtung und die Spaltprojektionseinrichtung dann synchron mit einer Relativbewegung des Produkts zum Inspektionssystem bzw. in einem einzigen Durchlauf des Produkts oder auch voneinander getrennt, bzw. seriell getaktet betrieben werden. Weiter kann vorgesehen sein, dass die Beleuchtungseinrichtung und/oder die Spaltprojektionseinrichtung einen Polarisationsfilter aufweist.

In einer vorteilhaften Ausführungsform des Inspektionssystems können mittels der Zeilenkamera Grundfarben erfasst werden, wobei mittels der Verarbeitungsvorrichtung aus einem Farbwert der Zeilenbildinformation eine Information zu einer Oberfläche eines Produkts abgeleitet werden kann. Die Zeilenkamera kann dann nicht nur Grauwerte erfassen, sondern auch zumindest zwei oder drei parallele Reihen von Pixel zur Erfassung der Grundfarben Rot, Grün und Blau aufweisen. Insbesondere wenn das Produkt mit unterschiedlichen Grundfarben beleuchtet wird, sind die Grundfarben besonders gut voneinander trennbar, d.h. es kann eine gleichzeitige Beleuchtung mit jeweils unterschiedlichen Grundfarben erfolgen. Darüber hinaus kann über den Farbwert der Zeilenbildinformation zumindest eine Information zu der Oberfläche des Produkts abgeleitet werden. Dies kann beispielsweise eine Materialinformation oder eine Information über eine Oberflächenbeschaffenheit sein.

Bevorzugt kann die erste Projektionsvorrichtung eine zweite Spaltprojektionseinrichtung aufweisen, wobei die zweite Projektionsvorrichtung eine zweite Beleuchtungseinrichtung aufweisen kann, wobei die erste und die zweite Spaltprojektionseinrichtung sowie die erste und die zweite Beleuchtungseinrichtung relativ zur Zeilenkamera koaxial angeordnet werden können. Insbesondere an ihrem Umfang kontaktierte Halbleiter, wie Chips bzw. Nacktchips können dann besonders schnell analysiert werden, da zwei parallele Längsseiten des Halbleiters mit jeweils Drahtverbindungen gleichzeitig beleuchtet werden können. Durch die koaxiale Anordnung relativ zur Zeilenkamera ergibt sich darüber hinaus eine gleichmäßige Beleuchtung der Drahtverbindungen bzw. des Produkts.

Das Inspektionssystem kann auch eine weitere Zeilenkamera aufweisen, wobei die weitere Zeilenkamera parallel zur Zeilenkamera bzw. ersten Zeilenkamera angeordnet werden kann. Mit der parallel angeordneten, weiteren Zeilenkamera ist es dann möglich, zeitgleich mit der ersten Zeilenkamera Zeilenbildinformationen zu erfassen und Analysebildinformationen des Produkts abzuleiten. Die weitere Zeilenkamera weist dann folglich eine weitere Erfassungsebene auf, wobei die weitere Erfassungsebene sich mit der Erfassungsebene bzw. ersten Erfassungsebene im Bereich des zu analysierenden Produkts bzw. Drahts schneidet, wobei die weitere Erfassungsebene dann nicht mehr orthogonal zur Oberfläche des Produkts bzw. der Substratoberfläche angeordnet sein kann. Beispielsweise kann dann auch mittels der weiteren Zeilenkamera eine Höheninformation des Drahts oder Halbleiterbauelements relativ zu einer Oberfläche des Produkts bzw. Substratoberfläche durch Triangulation bestimmt werden. Darüber hinaus wird es möglich, auch übereinander angeordnete Drähte sicher zu erkennen. Auch eventuell vorhandene Abschattungen sind durch die parallele Aufnahme mit der weiteren Zeilenkamera dann von geringer Bedeutung für das Analyseergebnis.

Nachfolgend wird eine bevorzugte Ausführungsform der Erfindung unter Bezugnahme auf die beigefügten Zeichnungen näher erläutert.

Es zeigen:
- **Fig. 1**: eine Prinzipdarstellung einer Ausführungsform eines Inspektionssystems in einer Vorderansicht;
- **Fig. 2**: eine Prinzipdarstellung des Inspektionssystems in einer Vorderansicht;
- **Fig. 3**: eine Prinzipdarstellung des Inspektionssystems in einer Seitenansicht;
- **Fig. 4**: eine Prinzipdarstellung des Inspektionssystems in einer Seitenansicht;
- **Fig. 5**: eine Prinzipdarstellung des Inspektionssystems in einer Draufsicht;
- **Fig. 6**: eine perspektivische Darstellung einer Beleuchtungseinrichtung;
- **Fig. 7**: eine perspektivische Darstellung einer Spaltprojektionseinrichtung.

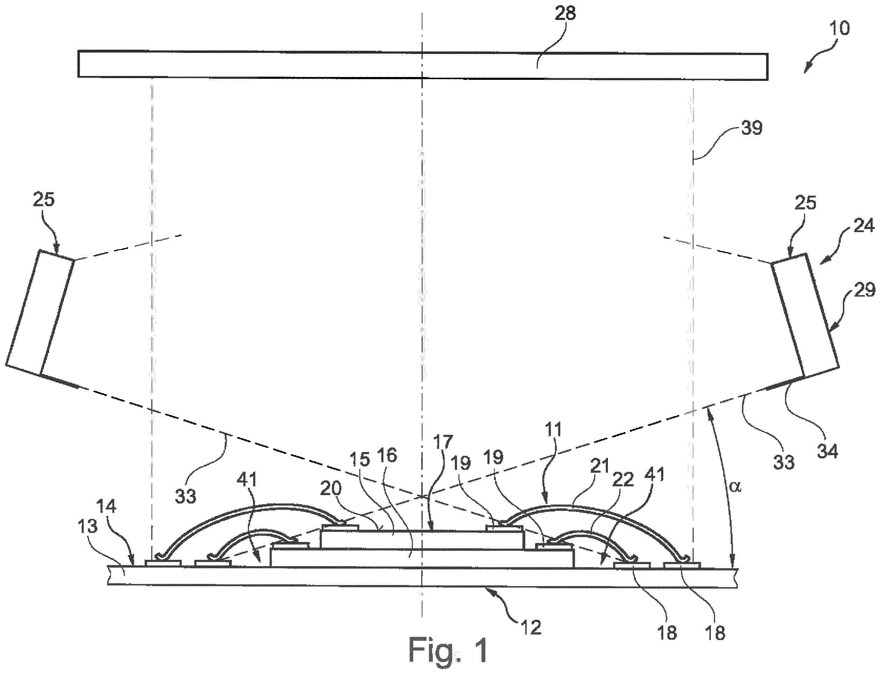

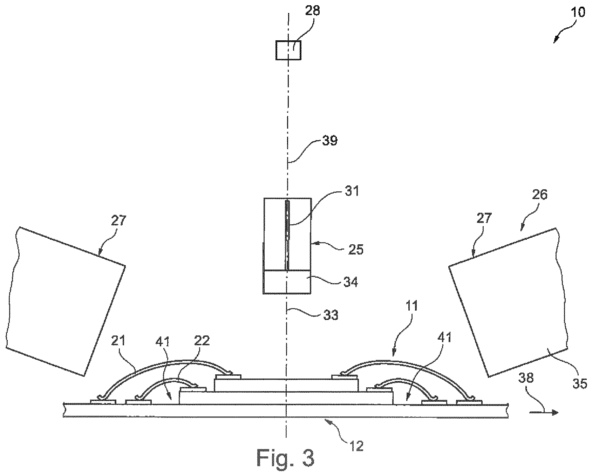

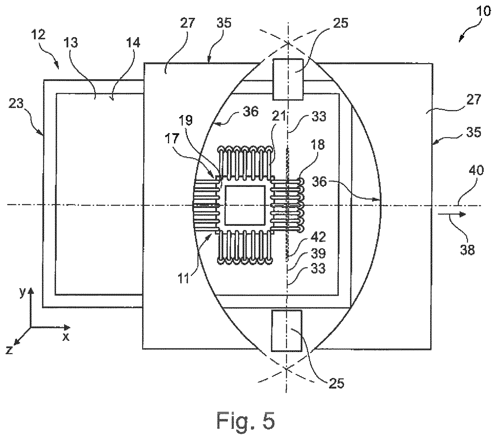

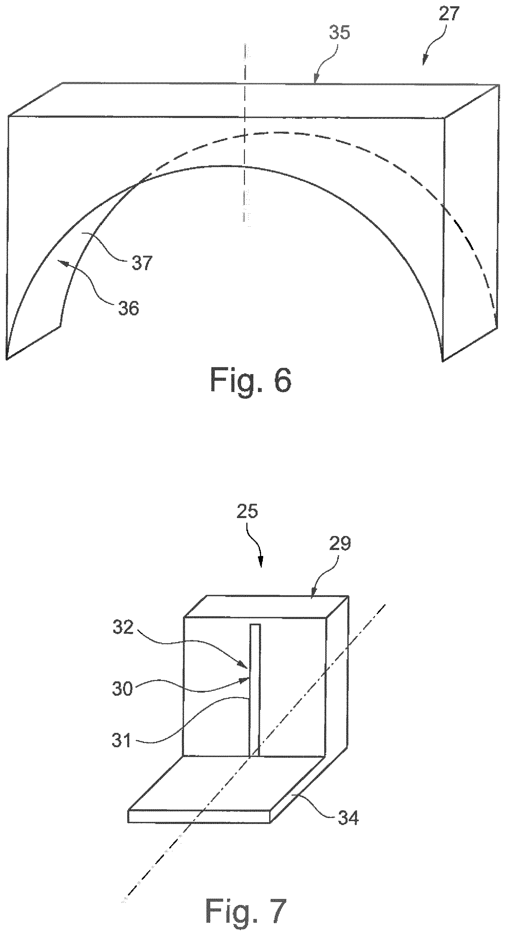

Eine Zusammenschau der **Fig. 1** bis 7 zeigt ein Inspektionssystem 10 zur Fehleranalyse von Drahtverbindungen 11 eines Produkts 12. Das Produkt 12 umfasst ein Substrat 13, auf dessen Oberfläche 14 zwei Halbleiterbauelemente 15 und 16 übereinander angeordnet sind. Die Halbleiterbauelemente 15 und 16 bilden einen Chip 17 aus. Die Drahtverbindungen 11 sind zwischen Anschlussflächen 18 auf der Oberfläche 14 des Substrats 13 und Anschlussflächen 19 auf einer Oberfläche 20 des Chips 17 bzw. der Halbleiterbauelemente 15 bzw. 16 zusammen mit die Anschlussflächen 18 und 19 verbindenden Drähten 21 und 22 ausgebildet. Das Produkt 12 ist dabei bereits in ein Gehäuse 23 eingesetzt.

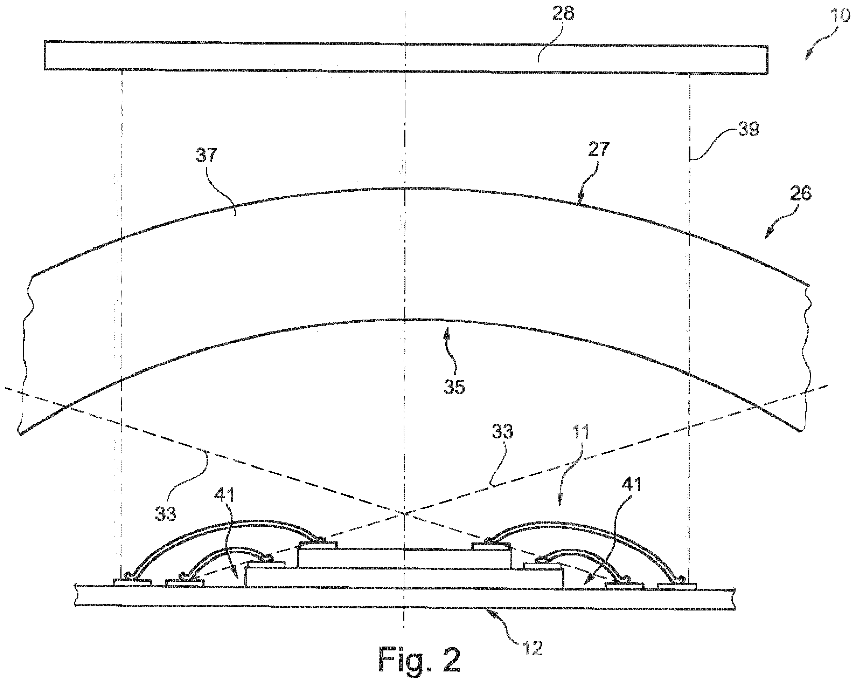

Das Inspektionssystem 10 umfasst eine erste Projektionsvorrichtung 24 mit zwei Spaltprojektionseinrichtungen 25, eine zweite Projektionsvorrichtung 26 mit zwei Beleuchtungseinrichtungen 27 und eine Zeilenkamera 28 sowie eine hier nicht dargestellte Verarbeitungsvorrichtung zur Verarbeitung von mit der Zeilenbildkamera 28 gewonnenen Zeilenbildinformationen. Die Zeilenkamera 28 ist so eingerichtet, dass mit der Zeilenkamera 28 Grundfarben erfassbar sind. Die **Fig. 1** und **2** zeigen dabei jeweils die erste Projektionsvorrichtung 24 und die zweite Projektionsvorrichtung 26 zur vereinfachten Veranschaulichung getrennt voneinander.

Die Spaltprojektionseinrichtung 25 weist einen Halter 29 mit einer Lichtleiteranordnung 30 auf. Die Lichtleiteranordnung 30 besteht aus Lichtleiterfasern, die bündelförmig dem Halter 29 zugeführt und in Form des hier dargestellten Spalts 31 angeordnet sind. Der Halter 29 bildet weiter eine Aperturblende 32 zur Ausbildung eines Lichtspalts 33 aus. Das dazu erforderliche Licht wird in die hier nicht dargestellten Lichtleitfasern eingekoppelt. Darüber hinaus ist an dem Halter 29 eine Abschirmblende 34 angeordnet, die den im Wesentlichen kollimierten Lichtspalt 33 begrenzt.

Die Beleuchtungseinrichtung 27 weist ein Gehäuse 35 auf, sowie einen bogenförmig ausgebildeten Diffusor 36. Der Diffusor 36 ist durch eine Kunststofffolie 37 ausgebildet. Innerhalb des Gehäuses 35 sind hier nicht dargestellte Leuchtdioden angeordnet, wobei mit der Beleuchtungseinrichtung 27 über den Diffusor 36 diffuses homogenes Licht in den Grundfarben (RGB) auf das Produkt 12 emittiert werden kann.

Die Zeilenkamera 28 ist oberhalb des Produkts 12 angeordnet, wobei das Produkt 12 relativ zur Zeilenkamera 28 in Richtung eines Pfeils 38 bewegbar ist. Dabei ist es grundsätzlich unerheblich, ob das Produkt 12 oder das Inspektionssystem 10 bewegt wird. Die Zeilenkamera 28 bildet eine Erfassungsebene 39 aus, die orthogonal zu der Oberfläche 14 des Substrats 13 verläuft, prinzipiell aber auch davon abweichend quer zu der Oberfläche 14 angeordnet sein kann. Das Produkt 12 wird entlang einer Bewegungsbahn 40 durch die Erfassungsebene 39 vollständig hindurch bewegt, sodass mit der Zeilenkamera 28 das Produkt 12 optisch abgetastet bzw. gescannt werden kann. Die Spaltprojektionseinrichtungen 25 und die Beleuchtungseinrichtungen 27 sind jeweils koaxial zu der Zeilenkamera 28 angeordnet. Der von der Spaltprojektionseinrichtung 25 erzeugte Lichtspalt 33 verläuft ausschließlich innerhalb der Erfassungsebene 39 und ist folglich somit mit dieser überlagert. Der Lichtspalt 33 ist mittels der Anordnung der Spaltprojektionseinrichtung 25 und mit Hilfe der Abschirmblende 34 so angeordnet und ausgebildet, dass der Lichtspalt 33 gegenüber dem Chip 17 abgegrenzt ist, sowie die Drähte 21 und 22 und in Teilen das Substrat 13 beleuchtet. Der Lichtspalt 33 wird dazu unter einem Winkel α relativ zu der Oberfläche 14 des Substrats 13 auf die Drähte 21 und 22 projiziert. Das bedeutet, dass Chip 17 nicht oder nur minimal mit dem Lichtspalt 33 beleuchtet wird. Weiter ist ein Bereich 41 des Substrats 13 unterhalb der Drähte 21 und 22 ebenfalls nicht mit dem Lichtspalt 33 beleuchtet. Die Oberfläche 20 sowie der Bereich 41 erscheinen dadurch sehr dunkel, sodass Drähte 21 und 22 in einer Nachfolgenden Verarbeitung der Zeilenbildinformationen bzw. der Analysebildinformationen besonders verlässlich und schnell erkannt werden können.

Die Beleuchtungseinrichtungen 27 sind vergleichsweise dicht gegenüber dem Chip 17 angeordnet, sodass das diffuse Licht eine optimale, allseitige Ausleuchtung der Drähte 21 und 22 ermöglicht. Auch die Beleuchtungseinrichtungen 27 sind relativ zu der Oberfläche 14 des Substrats 13 geneigt angeordnet. Je nachdem welche der Leuchtdioden der Beleuchtungseinrichtung 27 aktiviert werden, kann ein polychromatisches oder monochromatisches, homogenes Licht erzeugt werden. Durch die Anordnung des Diffusors 36 wird es möglich, dass eine Bildung von Schatten, die eine Bildverarbeitung der Analysebildinformation erschweren könnte, vermieden wird. Die Zeilenkamera 28, die Beleuchtungseinrichtungen 27 und die Spaltprojektionseinrichtungen 25 sind einstellbar ausgebildet, d.h. sie können in ihrem Abstand und ihrer Neigung relativ zum Produkt 12 beliebig verändert und fixiert werden. Somit wird es möglich, eine Vielzahl von Produkten mit unterschiedlichen Geometrien und Abmessungen flexibel zu analysieren.

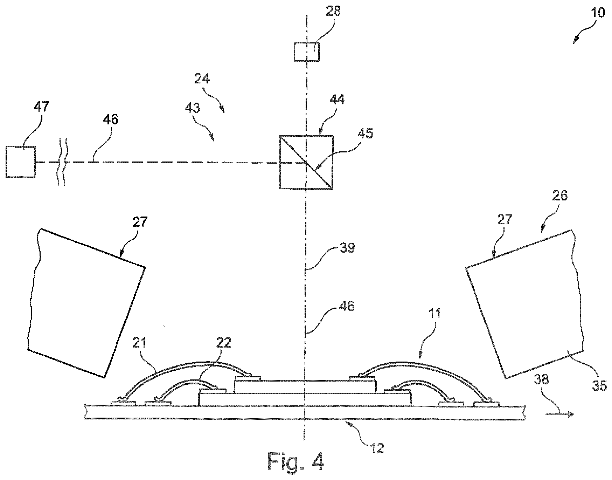

Die **Fig. 4** zeigt eine Spaltprojektionseinrichtung 43 der ersten Projektionsvorrichtung 24, die zusammen mit der Spaltprojektionseinrichtung 25 Bestandteil der ersten Projektionsvorrichtung 24 sein kann. Die Spaltprojektionseinrichtung 43 ist relativ zu der Zeilenkamera 28 parallel angeordnet und weist eine stabförmige Prismenanordnung 44 auf, die einen einem teildurchlässigen Spiegel 45 ausbildet. Die Prismenanordnung 44 ist innerhalb der Erfassungsebene 39 zwischen der Zeilenkamera 28 und dem Produkt 12 angeordnet. Von einem Gehäuse 47 mit einer hier nicht dargestellten Lichtquelle der ersten Projektionsvorrichtung 24 wird ein Lichtspalt 46, der hier parallel zum Produkt 12 verläuft und eine Breite der Erfassungsebene 39 vollständig ausfüllt, auf die Prismenanordnung 44 projiziert. Der Lichtspalt 46 wird durch den teildurchlässigen Spiegel 45 um 90° in die Erfassungsebene 39 umgelenkt bzw. eingekoppelt. Eine Totalreflexion des Lichtspalts 46 am Produkt 12 kann dann von der Zeilenkamera 28 durch den teildurchlässigen Spiegel 45 hindurch erfasst werden. Die Drähte 21 und 22 erscheinen dadurch sehr dunkel, sodass diese in einer Nachfolgenden Verarbeitung der Zeilenbildinformationen bzw. der Analysebildinformationen besonders verlässlich und schnell erkannt werden können.

Bei einem Scan der Drahtverbindungen 11 kann die Erfassungsebene 39 auf einen Analysebereich 42 beschränkt werden, der zumindest die Drahtverbindungen 11 einschließt und nicht wesentlich darüber hinaus geht. So kann eine noch schnellere Fehleranalyse durchgeführt werden. In einem ersten Durchlauf bzw. Scan des Produkts 12 wird das Produkt 12 von einer ersten Position in Schritten von 3 µm zu einer zweiten Position und weiter zur Endposition bewegt, wobei in jeder Position mittels der Zeilenkamera 28 eine Zeilenbildinformation erfasst wird. Dabei erfolgt eine Beleuchtung des Analysebereichs 42 mit der ersten Projektionsvorrichtung 24 und nachfolgend oder davor eine Beleuchtung des Analysebereichs 42 mit der zweiten Projektionsvorrichtung 26, wobei jeweils eine Zeilenbildinformation aufgenommen wird. Die Verarbeitungsvorrichtung bildet aus der Mehrzahl von Zeilenbildinformationen der jeweiligen Positionen durch Überlagerung eine Analysebildinformation des Produkts 12 aus. Durch einen Scan in Richtung einer X-Achse des Produkts 12 werden zunächst die parallel zur Zeilenkamera 28 verlaufenden Drähte 21 und 22 analysiert, wobei bei einem nachfolgenden Scan das Produkt 12 um 90° gedreht wird, sodass die dann parallel zur Zeilenkamera 28 verlaufenden Drähte 21 und 22 analysiert werden. Demnach wird das Produkt 12 zunächst entlang seiner X-Achse und nachfolgend entlang seiner Y-Achse gescannt. Dadurch wird es möglich, auch mit der Zeilenkamera 28 mit geringerer Auflösung durch die Überlagerung der Zeilenbildinformationen und Abstände der jeweiligen Positionen zur Aufnahme einer Zeilenbildinformation vergleichsweise dünne Drähte 21 und 22 mit beispielsweise 18 µm Durchmesser zu erkennen. In einer Längsrichtung der Drähte 21 und 22 ist hingegen eine verbesserte Auflösung der Zeilenkamera 28 durch Überlagerung von Zeilenbildinformationen nicht erforderlich. Quer zur Erfassungsebene 39 verlaufende Drähte 21 und 22 können daher ohne eine Überlagerung der Zeilenbildinformation gescannt werden, was eine Fehleranalyse noch weiter beschleunigt.

### Bezugszeichenliste

- 10: Inspektionssystem
- 11: Drahtverbindung
- 12: Produkt
- 13: Substrat
- 14: Oberfläche
- 15: Halbleiterbauelement
- 16: Halbleiterbauelement
- 17: Chip
- 18: Anschlussfläche
- 19: Anschlussfläche
- 20: Oberfläche
- 21: Draht
- 22: Draht
- 23: Gehäuse
- 24: erste Projektionsvorrichtung
- 25: Spaltprojektionseinrichtung
- 26: zweite Projektionsvorrichtung
- 27: Beleuchtungseinrichtung
- 28: Zeilenkamera
- 29: Halter
- 30: Lichtleiteranordnung
- 31: Spalt
- 32: Aperturblende
- 33: Lichtspalt
- 34: Abschirmblende
- 35: Gehäuse
- 36: Diffusor
- 37: Kunststofffolie
- 38: Pfeil
- 39: Erfassungsebene
- 40: Bewegungsbahn
- 41: Bereich
- 42: Analysebereich
- 43: Spaltprojektionseinrichtung
- 44: Prismenanordnung
- 45: Spiegel
- 46: Lichtspalt
- 47: Gehäuse

## Patentansprüche

1. Verfahren zur Fehleranalyse einer Drahtverbindung (11) zwischen einem Substrat (13) und einem Halbleiterbauelement (15, 16) eines Produkts (12), mit einem Inspektionssystem (10), wobei das Inspektionssystem eine erste Projektionsvorrichtung (24), eine Zeilenkamera (28) und eine Verarbeitungsvorrichtung umfasst, wobei die erste Projektionsvorrichtung zumindest eine Spaltprojektionseinrichtung (25) aufweist, wobei mittels der Spaltprojektionseinrichtung ein Lichtspalt (33) auf einen Draht (21, 22) der Drahtverbindung projiziert wird, wobei in einer quer, vorzugsweise orthogonal, zu einer Substratoberfläche (14) verlaufenden Erfassungsebene (39) der Zeilenkamera am Draht reflektiertes Licht des Lichtspalts mittels der Zeilenkamera erfasst wird, wobei mittels der Verarbeitungsvorrichtung aus einer Mehrzahl von Zeilenbildinformationen der Zeilenkamera eine Analysebildinformation des Produkts abgeleitet wird, wobei der Lichtspalt innerhalb der Erfassungsebene verlaufend auf das Produkt projiziert wird, wobei die Spaltprojektionseinrichtung (25) seitlich quer relativ zu der Zeilenkamera (28) so angeordnet ist, dass der Lichtspalt (33) auf den Draht (21, 22) projiziert wird, wobei das Inspektionssystem eine zweite Projektionsvorrichtung (26) umfasst, wobei die zweite Projektionsvorrichtung zumindest eine Beleuchtungseinrichtung (27) aufweist, wobei mittels der Beleuchtungseinrichtung diffuses Licht auf das Produkt projiziert wird, wobei am Produkt in der Erfassungsebene reflektiertes Licht des diffusen Lichts mittels der Zeilenkamera erfasst wird,
**dadurch gekennzeichnet,**
**dass** das Halbleiterbauelement (15, 16) von dem Lichtspalt (33) unbeleuchtet ist.

2. Verfahren nach Anspruch 1,
**dadurch gekennzeichnet,**
**dass** mittels der Verarbeitungsvorrichtung die Mehrzahl von Zeilenbildinformationen der Zeilenkamera (28) in einer Bewegungsrichtung des Produkts (12) mit einem Versatz überlagert werden, wobei der Versatz kleiner ist als eine physikalische Bildauflösung der Zeilenkamera.

3. Verfahren nach Anspruch 1 oder 2,
**dadurch gekennzeichnet,**
**dass** das Produkt (12) einmalig in Richtung einer X-Achse und/oder einer Y-Achse des Produkts relativ zur Zeilenkamera (28) bewegt und optisch abgetastet wird, wobei den Projektionsvorrichtungen (24, 26) zugeordnete Analysebildinformationen gewonnen werden.

4. Verfahren nach einem der vorangehenden Ansprüche,
**dadurch gekennzeichnet,**
**dass** das Produkt (12) in zumindest zwei Ebenen einer Z-Achse des Produkts optisch abgetastet wird.

5. Verfahren nach einem der vorangehenden Ansprüche,
**dadurch gekennzeichnet,**
**dass** das Licht der Projektionsvorrichtungen (24, 26) in einer zeitlichen Abfolge auf das Produkt (12) projiziert werden, wobei die Zeilenkamera (28) mit den Projektionsvorrichtungen synchronisiert ist.

6. Verfahren nach einem der vorangehenden Ansprüche,
**dadurch gekennzeichnet,**
**dass** aus einer Verteilung des auf einer Oberfläche des Drahts (21, 22) reflektierten Lichtstrahls mittels der Verarbeitungsvorrichtung eine Höheninformation und/oder geometrische Information des Drahts ermittelt wird.

7. Verfahren nach einem der vorangehenden Ansprüche,
**dadurch gekennzeichnet,**
**dass** mittels der Verarbeitungsvorrichtung das vom Produkt (12) reflektierte Licht des diffusen Lichts hinsichtlich Farbton, Helligkeit und/oder Sättigung analysiert wird.

8. Verfahren nach einem der vorangehenden Ansprüche,
**dadurch gekennzeichnet,**
**dass** mittels der Verarbeitungsvorrichtung den Projektionsvorrichtungen (24, 26) zugeordnete Analysebildinformationen überlagert und ausgewertet werden.

9. Verfahren nach einem der vorangehenden Ansprüche,
**dadurch gekennzeichnet,**
**dass** die Zeilenkamera (28) quer zu einer Bewegungsrichtung eines Produkts (12) angeordnet wird, wobei die Erfassungsebene (39) parallel oder quer zu dem Draht (21, 22) verläuft.

10. Verfahren nach einem der vorangehenden Ansprüche,
**dadurch gekennzeichnet,**
**dass** eine Abgrenzung des Lichtspalts (33) gegenüber dem Halbleiterbauelement (15, 16) und/oder dem Substrat (13) die Spaltprojektionseinrichtung (25) mit zumindest einer Abschirmblende (34) erfolgt, wobei der Lichtspalt unter einem spitzen Winkel (α) relativ zu einer Oberfläche (14, 20) des Produkts auf den Draht (21, 22) projiziert wird.

11. Verfahren nach einem der vorangehenden Ansprüche,
**dadurch gekennzeichnet,**
**dass** ein bogenförmigen Diffusor (36) der Beleuchtungseinrichtung (27) seitlich parallel relativ zu der Zeilenkamera (28) angeordnet wird.

12. Verfahren nach einem der vorangehenden Ansprüche,
**dadurch gekennzeichnet,**
**dass** ein ebener Diffusor der Beleuchtungseinrichtung (27) parallel relativ zu dem Produkt (12) angeordnet wird.

13. Verfahren nach einem der vorangehenden Ansprüche,
**dadurch gekennzeichnet,**
**dass** eine Lichtleiteranordnung oder Leuchtdioden in einer bogenförmigen und/oder ebenen Anordnung der Beleuchtungseinrichtung (27) verwendet werden.

14. Verfahren nach einem der vorangehenden Ansprüche,
**dadurch gekennzeichnet,**
**dass** die Beleuchtungseinrichtung (27) und/oder die Spaltprojektionseinrichtung (25) Licht der Wellenlängenbereiche Rot, Grün und Blau (RGB), Infrarot (IR) und/oder Ultraviolett (UV) emittiert.

15. Verfahren nach einem der vorangehenden Ansprüche,
**dadurch gekennzeichnet,**
**dass** mittels der Zeilenkamera (28) Grundfarben erfasst werden, wobei mittels der Verarbeitungsvorrichtung aus einem Farbwert der Zeilenbildinformationen eine Information zu einer Oberfläche (14, 20) des Produkts abgeleitet wird.

16. Verfahren nach einem der vorangehenden Ansprüche,
**dadurch gekennzeichnet,**
**dass** die erste Projektionsvorrichtung (24) eine zweite Spaltprojektionseinrichtung (25) aufweist, und dass die zweite Projektionsvorrichtung (26) eine zweite Beleuchtungseinrichtung (27) aufweist, wobei die erste und die zweite Spaltprojektionseinrichtung sowie die erste und die zweite Beleuchtungseinrichtung relativ zur Zeilenkamera (28) koaxial angeordnet werden.

17. Verfahren nach einem der vorangehenden Ansprüche,
**dadurch gekennzeichnet,**
**dass** eine weitere Zeilenkamera des Inspektionssystems (10) parallel zur Zeilenkamera (28) angeordnet wird.

## Claims

1. A method for defect analysis of a wire connection (11) between a substrate (13) and a semiconductor component (15, 16) of a product (12), comprising an inspection system (10), the inspection system comprising a first projection device (24), a line scan camera (28) and a processing device, the first projection device having at least one slit projection means (25), the slit projection means projecting a light slit (33) onto a wire (21, 22) of the wire connection, light of the light slit reflected by the wire in a detection plane (39) of the line scan camera extending transversely, preferably orthogonally, to a substrate surface (14) being detected by means of the line scan camera, analysis image information of the product being derived from a plurality of line scan image information of the line scan camera by means of the processing device, the light slit being projected onto the product so as to extend within the detection plane, the slit projection means (25) being arranged laterally transversely in relation to the line scan camera (28) in such a manner that, the light slit (33) is projected onto the wire (21, 22), the inspection system comprising a second projection device (26), the second projection device having at least one illuminating means (27), the illuminating means projecting diffuse light onto the product, light of the diffuse light reflected by the product in the detection plane being detected by means of the line scan camera
**characterized in that**
the semiconductor component (15, 16) is unlit by the light slit (33).

2. The method according to claim 1,
**characterized in that**
an offset is superimposed on the plurality of line scan image information of the line scan camera (28) in a direction of movement of the product (12) by means of the processing device, the offset being smaller than a physical image resolution of the line scan camera.

3. The method according to claim 1 or 2,
**characterized in that**
the product (12) is moved once in the direction of an X-axis and/or a Y-axis of the product in relation to the line scan camera (28) and is optically scanned, analysis image information associated with the projection devices (24, 26) being obtained.

4. The method according to any one of the preceding claims,
**characterized in that**
the product (12) is optically scanned in at least two planes of a Z-axis of the product.

5. The method according to any one of the preceding claims,
**characterized in that**
the light of the projection devices (24, 26) is projected onto the product (12) in a time sequence, the line scan camera (28) being synchronized with the projection devices.

6. The method according to any one of the preceding claims,
**characterized in that**
height information and/or geometrical information of the wire is obtained by means of the processing device from a distribution of the light beam reflected by a surface of the wire (21, 22).

7. The method according to any one of the preceding claims,
**characterized in that**
the light of the diffuse light reflected by the product (12) is analyzed by means of the processing device in terms of hue, brightness and/or saturation.

8. The method according to any one of the preceding claims,
**characterized in that**
analysis image information associated with the projection devices (24, 26) is superimposed and evaluated by means of the processing device.

9. The method according to any one of the preceding claims,
**characterized in that**
the line scan camera (28) is arranged transversely to a direction of movement of a product (12), the detection plane (39) extending parallel or transversely to the wire (21, 22).

10. The method according to any one of the preceding claims,
**characterized in that**
the light slit (33) is blocked from the semiconductor component (15, 16) and/or from the substrate (13) by means of at least one screening shade (34), the light slit being projected onto the wire (21, 22) at an acute angle α in relation to a surface (14, 20) of the product.

11. The method according to any one of the preceding claims,
**characterized in that**
an arc-shaped diffuser (36) of the illuminating means (27) is arranged laterally parallel in relation to the line scan camera (28).

12. The method according to any one of the preceding claims,
**characterized in that**
a plane diffuser of the illuminating means (27) is arranged parallel in relation to the product (12).

13. The method according to any one of the preceding claims,
**characterized in that**
a light guide assembly or light-emitting diodes are used in an arc-shaped and/or plane arrangement of the illuminating means (27).

14. The method according to any one of the preceding claims,
**characterized in that**
the illuminating means (27) and/or the slit projection means (25) emits light in the wavelength ranges red, green and blue (RGB), infrared (IR) and/or ultraviolet (UV).

15. The method according to any one of the preceding claims,
**characterized in that**
primary colors are detected by means of the line scan camera (28), information regarding a surface (14, 20) of the product being derived from a color value of the line scan image information by means of the processing device.

16. The method according to any one of the preceding claims,
**characterized in that**
the first projection device (24) has a second slit projection means (25), and **in that** the second projection device (26) has a second illuminating means (27), the first and second slit projection means and the first and second illuminating means being arranged coaxially in relation to the line scan camera (28).

17. The method according to any one of the preceding claims,
**characterized in that**
another line scan camera of the inspection system (10) is arranged parallel to the line scan camera (28)..

## Revendications

1. Procédé pour un analyse de défaut d'une connexion par fil (11) entre un substrat (13) et un composant semi-conducteur (15, 16) d'un produit (12), comprenant un système d'inspection (10), le système d'inspection comprenant un premier dispositif de projection (24), une caméra linéaire (28) et un dispositif de traitement, le premier dispositif de projection ayant au moins un moyen de projection à fente (25), le moyen de projection à fente projetant une fente de lumière (33) sur un fil (21, 22) de la connexion par fil, de la lumière de la fente de lumière réfléchie par le fil dans un plan de détection (39) de la caméra linéaire s'étendant transversalement, de préférence orthogonalement, à une surface de substrat (14) étant détectée au moyen de la caméra linéaire, une information d'image d'analyse du produit étant dérivée d'une pluralité d'informations d'image linéaire au moyen du dispositif de traitement, la fente de lumière étant projetée au produit de manière à s'étendre à l'intérieur du plan de détection, le moyen de projection à fente (25) étant disposé latéralement de manière transversale par rapport à la caméra linéaire (28) de manière que la fente de lumière (33) est projetée sur le fil (21, 22), le système d'inspection comprenant un deuxième dispositif de projection (26), le deuxième dispositif de projection ayant au moins un moyen d'éclairage (27), le moyen d'éclairage projetant de la lumière diffuse sur le produit, de la lumière de la lumière diffuse réfléchie par le produit dans le plan de détection étant détectée au moyen de la caméra linéaire,
**caractérisé en ce que**
le composant semi-conducteur (15, 16) n'est pas éclairé par la fente de lumière (33).

2. Procédé selon la revendication 1,
**caractérisé en ce qu'**
un décalage est superposé à la pluralité d'informations d'image d'analyse de la caméra linéaire (28) dans une direction de mouvement du produit (12) au moyen du dispositif de traitement, le décalage étant plus petit qu'une résolution d'image physique de la caméra linéaire.

3. Procédé selon la revendication 1 ou 2,
**caractérisé en ce que**
le produit (12) est mû une fois dans la direction d'un axe des x et/ou d'un axe des y du produit par rapport à la caméra linéaire (28) et est balayé optiquement, des information d'image d'analyse associées aux dispositifs de projection (24, 26) étant obtenues.

4. Procédé selon l'une quelconque des revendications précédentes,
**caractérisé en ce que**
le produit (12) est balayé optiquement au moins dans deux plans d'un axe des z du produit.

5. Procédé selon l'une quelconque des revendications précédentes,
**caractérisé en ce que**
la lumière des dispositifs de projection (24, 26) est projetée sur le produit (12) dans une séquence temporelle, la caméra linéaire (28) étant synchronisée avec les dispositifs de projection.

6. Procédé selon l'une quelconque des revendications précédentes,
**caractérisé en ce qu'**
une information de hauteur et/ou une information géométrique du fil est obtenue au moyen du dispositif de traitement d'une distribution du faisceau lumineux réfléchi par une surface du fil (21, 22).

7. Procédé selon l'une quelconque des revendications précédentes,
**caractérisé en ce que**
la lumière de la lumière diffuse réfléchie par le produit (12) est analysée au moyen du dispositif de traitement en termes de la teinte, la luminosité et/ou la saturation.

8. Procédé selon l'une quelconque des revendications précédentes,
**caractérisé en ce que**
les informations d'image d'analyse associées aux dispositifs de projection (24, 26) sont superposées et évaluées au moyen du dispositif de traitement.

9. Procédé selon l'une quelconque des revendications précédentes,
**caractérisé en ce que**
la caméra linéaire (28) est disposée transversalement à une direction de mouvement d'un produit (12), le plan de détection (39) s'étendant parallèlement ou transversalement au fil (21, 22).

10. Procédé selon l'une quelconque des revendications précédentes,
**caractérisé en ce que**
la fente de lumière (33) est bloquée du composant semi-conducteur (15, 16) et/ou du substrat (13) au moyen d'au moins un écran de blindage (34), la fente de lumière étant projetée sous un angle aigu (α) par rapport à une surface (14, 20) du produit sur le fil (21, 22).

11. Procédé selon l'une quelconque des revendications précédentes,
**caractérisé en ce qu'**
un diffuseur (36) en forme d'arc du moyen d'éclairage (27) est disposé latéralement de manière parallèle par rapport à la caméra linéaire (28).

12. Procédé selon l'une quelconque des revendications précédentes,
**caractérisé en ce qu'**
un diffuseur plan du moyen d'éclairage (27) est disposé parallèlement par rapport au produit (12).

13. Procédé selon l'une quelconque des revendications précédentes,
**caractérisé en ce qu'**
un ensemble de guide de lumière ou des diodes électroluminescentes sont utilisés dans un agencement en forme d'arc et/ou plan du moyen d'éclairage (27).

14. Procédé selon l'une quelconque des revendications précédentes,
**caractérisé en ce que**
le moyen d'éclairage (27) et/ou le moyen de projection à fente (25) émet de la lumière dans les plages de longueurs d'onde rouge, vert et bleu (RVB), infrarouge (IR) et/ou ultraviolet (UV).

15. Procédé selon l'une quelconque des revendications précédentes,
**caractérisé en ce que**
des couleurs primaires sont détectées au moyen de la caméra linéaire (28), une information concernant la surface (14, 20) du produit étant dérivée d'une valeur de couleur des informations d'image linéaire au moyen du dispositif de traitement.

16. Procédé selon l'une quelconque des revendications précédentes,
**caractérisé en ce que**
le premier dispositif de projection (24) a un deuxième moyen de projection à fente (25), et **en ce que** le deuxième dispositif de projection (26) a un deuxième moyen d'éclairage (27), le premier et le deuxième moyen de projection à fente et le premier et le deuxième moyen d'éclairage étant disposés coaxialement par rapport à la caméra linéaire (28).

17. Procédé selon l'une quelconque des revendications précédentes,
**caractérisé en ce qu'**
une autre caméra linéaire du système d'inspection (10) est disposée parallèlement à la caméra linéaire (28).
